# FASCICULE DE BREVET EUROPEEN

(11) **EP 0 734 066 B1**
(45) Date de publication et mention de la délivrance du brevet: **02.06.1999**
(21) Numéro de dépôt: 96104041.7
(22) Date de dépôt: 14.03.1996
(51) Int. Cl.: H01L 25/065, H01L 23/40

(54) **Module électronique de puissance**
Elektronischer Leistungsmodul
Electronic power module

(30) Priorité: 21.03.1995 FR 9503279
(43) Date de publication de la demande: 25.09.1996
(73) Titulaire: ASULAB S.A., CH-2501 Bienne (CH)
(72) Inventeur: Jaeger, Gérard, CH-1807 Blonay (CH); Dinger, Rudolf, CH-2024 St-Aubin (CH)
(74) Mandataire: Patry, Didier Marcel Pierre

(56) Documents cités:
- EP-A- 0 102 058
- EP-A- 0 619 605
- FR-A- 2 555 812
- US-A- 4 899 255

## Description

La présente invention concerne un module électronique de puissance comportant plusieurs circuits intégrés de puissance qui peuvent être, par exemple, des transistors bipolaires à grilles isolées (IGBT).

Beaucoup de puces de circuits intégrés de puissance, les IGBTs notamment, comportent deux plages de contact situées sur des faces opposées de la puce. Nous appellerons respectivement celles-ci la plage de contact "supérieure" et la plage de contact "inférieure". Lorsque plusieurs puces sont assemblées en parallèle dans un même module, il est connu d'assurer la connexion des plages de contact inférieures des puces au moyen d'un substrat conducteur sur lequel on les fait adhérer. Pour assurer la liaison des plages de contact supérieures de chacune des puces on a habituellement recours à des connexions individuelles par fils d'aluminium soudés.

Les modules réalisés conformément à la description ci-dessus présentent des défauts. En effets, les forts courants circulant par intermittence dans les circuits intégrés de puissance d'un tel module, produisent une chaleur considérable. Cette chaleur peut être partiellement évacuée par le substrat conducteur sur lequel les plages de contact inférieures adhèrent. Toutefois, la chaleur produite au niveau des plages de contact supérieures produit des brusques variations de la température dans les connexions par fils. Ces variations de température engendrent une fatigue considérable du métal, ce qui diminue grandement la fiabilité du module de puissance.

Un premier but de la présente invention est de fournir un module de puissance dans lequel la fiabilité des moyens de liaison électrique avec les plages de contact supérieures des circuits intégrés de puissance est peu sensible aux brusques variations de températures.

Un deuxième but de la présente invention est de fournir un module de puissance dans lequel la chaleur produite par les circuits intégrés de puissance au niveau de leurs plages de contact supérieures peut être évacuée sans produire de variations de températures excessives.

Le document EP 0 532 244 A1 décrit déjà un module de puissance conçu pour atteindre les deux buts susmentionnés. Le module de puissance décrit dans ce document antérieur a une forme qui rappelle une boîte de conserve dans laquelle les circuits intégrés de puissance seraient disposés côte à côte parallèlement au fond de la boîte. Des éléments de contact en forme de plaque et un ressort sont prévus pour fournir un chemin pour la chaleur et l'électricité entre, d'une part, les plages de contact et chaque puce et, d'autre part, les parois inférieures et supérieures du module (le fond et le couvercle de la boîte). Les éléments de contact sont disposés contre la face inférieure et la face supérieure de la puce. Finalement, le ressort, qui est comprimé entre l'élément de contact supérieur et la paroi supérieure du module est prévu pour rappeler la puce et les éléments de contact en direction de la paroi inférieure du module. On comprendra que la construction qui vient d'être décrite forme une structure en sandwich dont tous les éléments sont comprimés entre la paroi supérieure et la paroi inférieure du module.

La construction en sandwich qui vient d'être décrite présente des défauts. On remarquera notamment qu'elle permet uniquement la réalisation de module dans lesquels les circuits intégrés de puissance sont reliés en parallèle. Le document EP 0 532 244 A1 enseigne, en effet, d'assembler plusieurs modules lorsqu'on veut réaliser des assemblages reliés de façon plus complexes. On remarquera d'autre part, que l'utilisation pour conduire la chaleur d'un ressort travaillant en compression nécessite de prévoir des moyens d'évacuation de la chaleur aussi bien à partir du dessus que du dessous du module de puissance, ce qui peut être une contrainte désavantageuse.

Le document EP-A-0 102 058 décrit aussi un module avec un ressort travaillant en tension.

Un autre but de la présente invention est donc de fournir un module de puissance pouvant accommoder des circuits intégrés de puissance entre eux selon de multiples configurations.

Encore un autre but de la présente invention est de fournir un module de puissance qui nécessite des moyens d'évacuation de la chaleur uniquement à partir d'un de ses côtés, dit côté inférieur.

A cet effet, la présente invention a pour objet un module électronique de puissance selon la revendication 1 comportant au moins un premier et un deuxième circuits intégrés de puissance, chacun desdits circuits intégrés comportant deux faces parallèles et opposées l'une à l'autre, lesdites faces comportant chacune une plage de contact du circuit intégré, ledit module comportant encore des moyens de liaison électrique et de conduction thermique pour, d'une part, relier lesdites plages de contact à l'extérieur dudit module et, d'autre part, évacuer la chaleur produite par lesdits circuits intégrés,
- lesdits moyens de liaison électrique et de conduction thermique comportant notamment des bandes de fixation réalisées en un matériau conducteur de chaleur et reliées thermiquement à des moyens d'évacuation de la chaleur, et des pièces de liaison supérieures réalisées en un matériau conducteur d'électricité et de chaleur,
- ledit premier circuit intégré étant disposé entre une première desdites bandes de fixation et une première desdites pièces de liaison supérieures, et ledit deuxième circuit intégré étant disposé entre une deuxième desdites bandes de fixation et une deuxième desdites pièces de liaison supérieures, lesdites première et deuxième bandes de fixation présentant chacune une face supérieure parallèle et opposée à une première desdites faces, dite face inférieure, d'un desdits premier et deuxième circuits intégrés, et lesdites première et deuxième pièces de liaison supérieures comportant chacune une face inférieure qui est parallèle et opposée à une deuxième desdites faces, dite face supérieure, d'un desdits premier et deuxième circuits intégrés,
- un premier et un deuxième ressorts étant encore prévus pour rappeler respectivement lesdites première et deuxième pièces de liaison supérieures en direction desdites première et deuxième bandes de fixation de manière à comprimer lesdits premier et deuxième circuits intégrés et à réaliser ainsi un contact électrique et thermique entre lesdites faces des circuits intégrés et lesdits moyens de liaison électrique et de conduction thermique,
ledit module électronique de puissance étant caractérisé en ce que lesdits premier et deuxième ressorts viennent se fixer sur lesdites première et deuxième bandes de fixation de manière à travailler en tension.

Grâce à ces caractéristiques, on fournit un module de puissance de construction particulièrement simple et donc aussi particulièrement économique.

D'autres caractéristiques et avantages de la présente invention apparaîtront au cours de la description qui va suivre, donnée uniquement à titre d'exemple et faite en se référant aux dessins annexés dans lesquels :
- la figure 1 est une vue en coupe selon I-I de la figure 2;
- la figure 2 est une vue de dessus d'un module de puissance selon un premier mode de réalisation de la présente invention, la coiffe du module ayant été retirée pour permettre de voir l'intérieur;
- la figure 3 est une vue en coupe identique à la figure 1 mais avec la coiffe du module;
- la figure 4 est le schéma électronique correspondant au module représenté sur les figures 1 à 3.

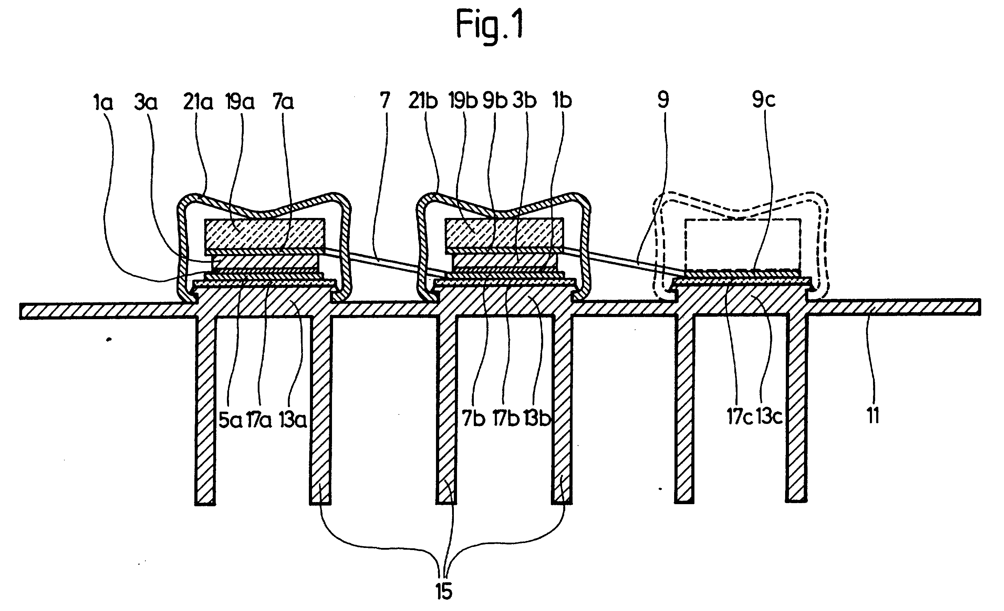

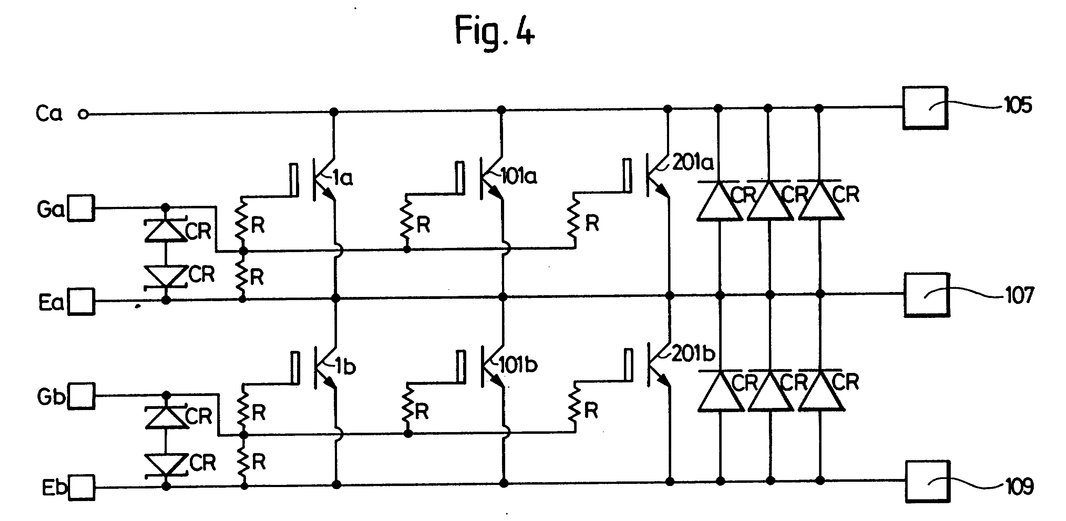

Le mode de réalisation de la présente invention représenté sur les figures 1 à 4 comporte six circuits intégrés de puissance du type IGBT. Ces IGBTs sont répartis en deux groupes de trois connectés en parallèle, et ces deux groupes de composants en parallèle sont ensuite reliés en série conformément au schéma électronique de la figure 4. Sur la figure 4, les six ICBTs sont respectivement référencés Q1 à Q6. Le schéma de la figure 4 est donné pour faciliter la compréhension de la description qui va suivre. Toutefois, la présente invention ne concerne nullement un schéma d'interconnexion particulier pour les composants électroniques d'un module et, de ce fait, la figure 4 ne sera pas commentée plus en détail.

La figure 1 est une vue partielle en coupe du module de puissance du présent exemple. Sur cette figure, seules deux des six puces IGBTs sont visibles. Ces deux puces sont référencées respectivement 1a et 1b. De plus, la figure 1 montre une partie des moyens de liaison électrique et de conduction thermique qui sont associés à ces deux puces.

Les circuits intégrés 1a et 1b comportent chacun une plage de contact de collecteur et une plage de contact d'émetteur situées respectivement sur la face supérieure et sur la face inférieure de la puce. Dans l'exemple de la figure 1, c'est la plage de contact d'émetteur qui se trouve en haut. Les IGBTs du présent exemple peuvent être, entre autres, du modèle Hitachi "MBM-A/BS/GS". Ce modèle d'IGBTs comporte, sur sa face supérieure, en plus de la plage de contact d'émetteur, une plage de contact de grille.

On voit sur la figure 1 que la face supérieure de chacun des IGBTs reçoit une pièce de contact d'émetteur qui est, de préférence, réalisée en aluminium. Les deux pièces de contact d'émetteur représentées sur la figure 1, sont référencées respectivement 3a et 3b. La face inférieure généralement plane de chacune des pièces de contact d'émetteur 3a et 3b est localement gravée en retrait de manière à ce qu'elle épouse la surface de la plage de contact d'émetteur de la puce, tout en laissant libre un accès à la plage de contact de grille. L'homme du métier comprendra qu'en ayant recours à des IGBTs sur lesquels la plage de contact de grille est disposée différemment, il serait possible de renoncer, par exemple, à la gravure en retrait des pièces de contact 3a et 3b.

Les ensembles formés chacun par une des puces IGBT et la pièce de contact d'émetteur qui lui est associée, sont pris en sandwich entre une pièce de liaison supérieure et une pièce de liaison inférieure. Sur la figure 1, les deux pièces de liaison associées à la puce 1a sont respectivement référencées 5a et 7a, et les deux pièces de liaison associées à la puce 1b sont référencées 7b et 9b. Ces pièces de liaison peuvent, par exemple, être réalisées en cuivre ou en aluminium, et sont prévues pour assurer aussi bien la liaison électrique avec les IGBTs, que l'évacuation de la chaleur produite au niveau des plages de contact d'émetteur et de collecteur. Nous reviendrons plus loin sur certaines particularités de configuration de ces pièces de liaison.

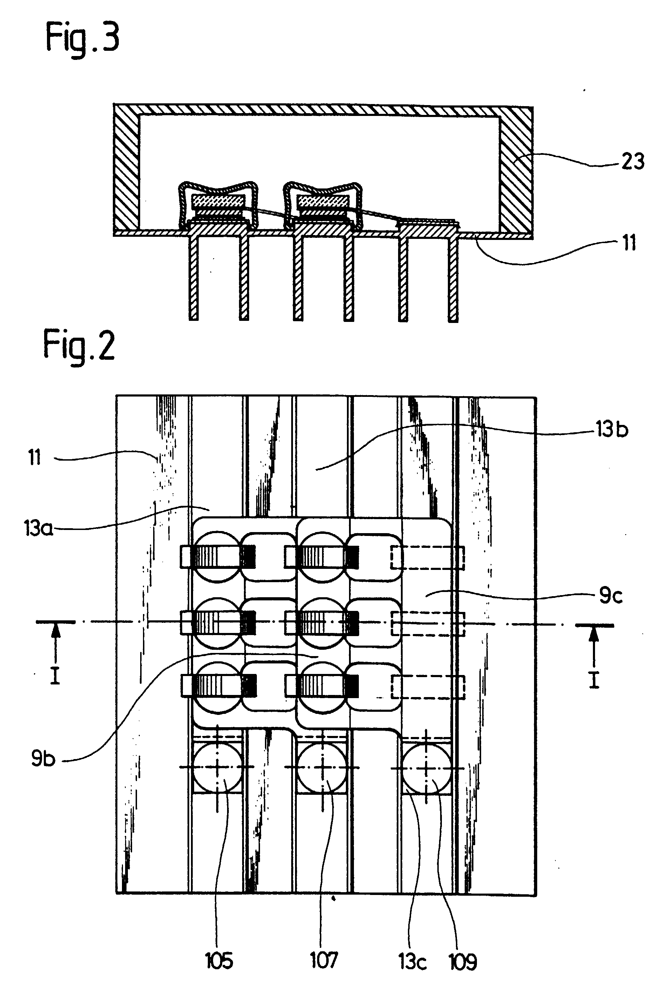

On voit encore sur la figure 1 que les différents éléments du module sont montés sur une plaque de support référencée 11. Cette plaque de support qui est également visible sur la figure 2 peut être réalisée, par exemple, en aluminium extrudé. Dans le présent exemple, la plaque de support comporte trois bandes de fixation surélevées qui sont respectivement référencées 13a, 13b et 13c. Comme on peut le voir sur la figure 2, dans le présent exemple, chaque bande de fixation est prévue pour recevoir trois IGBTs.

En se reportant à nouveau à la figure 1, on voit que, dans cet exemple, la plaque de support 11 comporte encore des moyens d'évacuation de la chaleur, formés par six ailettes qui sont collectivement référencées 15, et placées directement sous les bandes de fixation 13a, 13b et 13c prévues pour recevoir les circuits intégrés de puissance et les moyens de connexion qui leur sont associés. On notera à ce propos qu'en lieu et place des ailettes, on peut prévoir que la partie inférieure de la plaque support soit munie de canaux de refroidissement dans lesquels circule un fluide caloporteur.

A cet effet, on voit encore sur la figure 1, qu'une fine couche de céramique référencée 17a est intercalée entre la pièce de liaison inférieure 5a et la bande de fixation 13a. De même, une fine couche de céramique 17b est intercalée entre la pièce de liaison inférieure 7b et la bande de fixation 13b. Ces deux couches de liaison sont prévues, tout à la fois pour isoler électriquement les pièces de liaison 5a et 7b des bandes de fixation 13a et 13b, et pour permettre à la chaleur se s'écouler des pièces de liaison vers la plaque de support 11.

Dans le présent exemple, les pièces de liaison supérieures 7a et 9b sont chacune coiffées d'un capuchon en céramique (ces capuchons sont respectivement référencés 19a et 19b). On voit, de plus, que deux ressorts en U 21a et 21b sont respectivement fixés par leurs extrémités aux bandes de fixation 13a et 13b. Chacun des ressorts 21a et 21b appuie avec sa partie médiane contre un des capuchons 19a et 19b de manière à rappeler ce capuchon en direction de la bande de fixation sur laquelle le ressort prend, par ailleurs, appui. Ainsi, on comprendra qu'ici, conformément à la présente invention les éléments formant chacune des structures en sandwich qui viennent d'être décrites, sont comprimés ensemble par l'action d'un des ressorts 21a et 21b. On remarquera, en outre, que les ressorts 21a et 21b travaillent en tension. En effet, chacun d'eux est tendu entre, d'une part, une des bandes de fixation 13a ou 13b et, d'autre part, un des capuchons 19a et 19b.

On comprendra que grâce à la construction qui vient d'être décrite, chacune des plages de contact d'émetteur et de collecteur des puces 1a et 1b, est maintenue en contact tant électrique que thermique avec une des pièces de liaison 5a, 7a, 7b et 9b. La pression exercée par chacun des ressorts suffit pour maintenir le contact entre les différentes pièces qui sont pressées les unes contre les autres. Il n'est donc pas nécessaire de recourir à des soudures. De plus, les faces des pièces qui se touchent étant planes, les forces de cisaillement, qui sont normalement produites par la dilatation le long d'un joint entre deux pièces, produisent simplement un glissement d'une face contre une autre. Tout risque de détérioration de la qualité de contacts électriques sous l'effet des variations de températures est de ce fait éliminé.

En se référant à nouveau à la figure 1, on voit qu'une pièce de liaison 9c est encore fixée sur le sommet de la troisième bande de fixation 13c. Une mince couche de céramique 17c est intercalée entre la bande de fixation 13c et la pièce de liaison 9c. L'épaisseur de la couche de céramique est choisie de façon à ce que la pièce de liaison 9c soit isolée électriquement de la bande de fixation 13c, tout en étant en contact thermique avec celle-ci. Nous reviendrons plus loin sur la fonction remplie par la pièce de liaison 9c dans le présent exemple.

Jusqu'ici, nous n'avons parlé que de deux puces IGBT. Toutefois, comme on l'aura déjà remarqué, dans le présent exemple, la bande de fixation 13a qui reçoit la puce la reçoit encore deux autres IGBTs référencés respectivement 101a et 201a et, de façon semblable, la bande de fixation 13b qui reçoit 1a puce 1b reçoit également deux autres IGBTs référencés respectivement 101b et 201b. Les six circuits intégrés 1a, 1b, 101a, 101b, 201a et 201b sont tous identiques.

On voit encore sur la figure 2 que la pièce de liaison supérieure 9b est, en fait, une bande de liaison que se partagent les trois IGBTs qui sont montés sur la bande de fixation 13b. De façon semblable, chacune des autres pièces de liaison 5a, 7a et 7b décrite en relation avec les IGBTs 1a et 1a est, en fait, une bande de liaison que se partagent trois IGBTs. On comprendra donc que les IGBTs qui sont montés sur une même bande de fixation sont reliés ensemble en parallèle. Finalement, notons que la pièce de liaison 9c qui est montée sur la bande de fixation 13c a également la forme d'une bande.

Nous venons de voir que les bandes de liaison 5a, 7a, 7b et 9b permettent la connexion des IGBTs en parallèle, nous allons voir maintenant de quelle manière ces pièces de liaison permettent de relier des IGBTs en série. On voit sur les figures 1 et 2 que la bande de liaison 9b qui relie ensemble les puces 1b, 101b et 201b forme, en fait, un côté d'une tôle 9 dont l'autre côté est constitué par la bande de liaison 9c qui est fixée sur la bande de fixation 13c. De même, bien que la figure 2 ne le montre pas, 1a bande de liaison supérieure 7a qui relie les plages de contact d'émetteur des puces 1a, 101a et 201a forme une moitié d'une tôle 7 dont l'autre moitié est constituée par la bande de liaison inférieure 7b reliant les plages de contact de collecteur des puces 1b, 101b et 201b.

Grâce à la configuration qui vient d'être décrite, la tôle 7 relie, en série, les deux groupes d'IGBTs montés respectivement sur les bandes de fixation 13a et 13b. L'homme du métier peut constater que la configuration qui vient d'être décrite correspond bien au schéma électronique de la figure 4. La tôle 9 formée par les bandes de liaison 9b et 9c peut avoir une forme identique à celle de la tôle 7. La tôle 9 est prévue pour conduire la chaleur produite au niveau des plages de contact d'émetteur des puces 1b, 101b et 201b jusqu'à la bande de fixation 13c et les moyens d'évacuation de la chaleur 15.

La construction que nous venons de décrire permet donc, d'une part, de connecter chacune des plages de contact des IGBTs et d'autre part, de fournir des chemins d'évacuation de la chaleur à partir de toutes les plages de contact des puces. En effet, les plages de contact de collecteur des IGBTs sont en contact thermique presque direct avec la bande de fixation 13a et 13b, et leurs plages de contact d'émetteur sont reliées thermiquement aux bandes de fixation 13b et 13c par l'intermédiaire des tôles 7 et 9.

La figure 3 représente schématiquement en coupe un module de puissance terminé. On voit notamment que la plaque de support 11 porte une coiffe 23 qui enferme les circuits intégrés et les moyens de liaison électrique et de conduction thermique. Conformément à ce qui est représenté sur le schéma de la figure 4, le module de puissance du présent exemple contient d'autres éléments de circuit électronique comme, par exemple, des moyens pour relier les plages de contact de grille des IGBTs. Toutefois, ces autres éléments de circuit ne transportent pas des courants élevés et, en conséquence, ils peuvent être réalisés de manière classique. C'est pour cette raison que ces autres éléments de circuits n'ont pas été représentés sur les figures 1 à 3.

Pour en terminer avec ce premier exemple de module de puissance selon la présente invention, nous allons donner, à titre d'exemple uniquement, une manière de connecter les IGBTs à l'extérieur du module de puissance. Si on se reporte à nouveau à la figure 2, on voit que les deux bandes de liaison inférieures 5a et 7b se prolonge et forme deux languettes de connexion référencées respectivement 105 et 107. La languette de connexion 105 forme une broche de connexion avec les plages de contact de collecteur des puces 1a, 101a et 201a, et la languette de connexion 107 forme une broche de connexion avec, d'une part, les plages de contact d'émetteur des puces 1a, 101a et 201a et, d'autre part, les plages de contact de collecteur des puces 1b, 101b et 201b. On voit finalement sur la figure 2 que la bande de liaison 9c se prolonge et forme une languette de connexion référencée 109. La languette de connexion 109 forme une broche de connexion avec les plages de contact d'émetteur des puces 1b, 101b et 201b.

## Revendications

1. Module électronique de puissance comportant au moins un premier et un deuxième circuits intégrés juxtaposés sur une plaque de support (1a, 1b),chacun desdits circuits intégrés comportant deux faces parallèles et opposées l'une à l'autre, lesdites faces comportant chacune des plages de contact du circuit intégré, ledit module comportant encore des moyens de liaison électriques et de conduction thermiques pour, d'une part, relier lesdites plages de contact à l'extérieur dudit module et, d'autre part, évacuer la chaleur produite par lesdits circuits intégrés caractérisé en ce que :
- les circuits intégrés sont des circuits intégrés de puissance,
- lesdits moyens de liaison électrique et de conduction thermique comportent notamment des bandes de fixation (13a, 13b, 13c) faisant saillie de ladite plaque support qui sont réalisées en un matériau conducteur de chaleur et reliées thermiquement à des moyens (15) d'évacuation de la chaleur, et des pièces de liaison supérieures (7a, 9b) réalisées en un matériau conducteur d'électricité et de chaleur,
- ledit premier circuit intégré (1b) est disposé entre une première desdites bandes de fixation (13b) et une première desdites pièces de liaison supérieures (9b), et ledit deuxième circuit intégré (la) étant disposé entre une deuxième desdites bandes de fixation (13a) et une deuxième desdites pièces de liaison supérieures (7a), lesdites première et deuxième bandes de fixation présentant chacune une face supérieure parallèle et opposée à une première desdites faces, dite face inférieure, d'un desdits premier et deuxième circuits intégrés (1a, 1b), et lesdites première et deuxième pièces de liaison supérieures (7a, 9b) comportant chacune une face inférieure qui est parallèle et opposée à une deuxième desdites faces, dite face supérieure, d'un desdits premier et deuxième circuits intégrés (1a, 1b),
- un premier et un deuxième ressorts (21a, 21b) sont encore prévus pour rappeler respectivement lesdites première et deuxième pièces de liaison supérieures (7a, 9b) en direction desdites première et deuxième bandes de fixation (13a, 13b) de manière à comprimer lesdites premier et deuxième circuits intégrés (1a, 1b) et à réaliser ainsi un contact électrique et thermique entre lesdites faces des circuits intégrés (1a, 1b) et lesdits moyens de liaison électrique et de conduction thermique, en ce que lesdits premier et deuxième ressorts (21a, 21b) viennent se fixer sur les saillies de lesdites première et deuxième bandes de fixation (13a, 13b) de manière à travailler en tension.

2. Module électronique de puissance selon la revendication 1, caractérisé en ce que ladite deuxième pièce de liaison supérieure (7a) est formée par une partie d'une tôle de métal (7) dont une autre partie forme une première pièce de liaison inférieure (7b) disposée entre ledit premier circuit intégré (1b) et ladite première bande de fixation (13b), de manière à ce que la chaleur produite par ledit deuxième circuit intégré (1a) au niveau de sa face supérieure soit conduite vers ladite première bande de fixation (13b) et à ce que ledit deuxième circuit intégré (1a) soit relié électriquement audit premier circuit intégré (1b) via ladite face supérieure dudit deuxième circuit intégré (1a).

3. Module électronique de puissance selon la revendication 1, caractérisé en ce que lesdits ressorts (21a, 21b) sont réalisés en un matériau conducteur et en ce que des capuchons (19a, 19b) réalisés en un matériau isolant sont respectivement intercalés entre, d'une part, lesdites pièces de liaison supérieures (7a, 9b) et, d'autre part, lesdits ressorts (21a, 21b) de manière à isoler lesdites pièces de liaison supérieures desdites bandes de fixation (13a, 13b).

4. Module électronique de puissance selon l'une des revendications 1 à 3, caractérisé en ce qu'une deuxième pièce de liaison inférieure (5a) est disposée entre ledit deuxième circuit intégré (1a) et ladite deuxième bande de fixation (13a), et en ce que des couches isolantes (17a, 17b) séparent lesdites pièces de liaison inférieures (5a, 7b) desdites bandes de fixation (13a, 13b).

5. Module électronique de puissance selon l'une des revendications 1 ou 2, caractérisé en ce que des couches isolantes séparent lesdites bandes de fixation desdits moyens d'évacuation de la chaleur.

6. Module électronique de puissance selon l'une des revendications 1, 2 ou 4, caractérisé en ce que ladite première pièce de liaison supérieure (9b) est formée par une partie d'une tôle de métal (9) dont une autre partie forme une pièce de liaison inférieure (9c) supplémentaire solidaire d'une bande de fixation supplémentaire (13c) de manière à ce que la chaleur produite par ledit premier circuit intégré (1b) au niveau de sa face supérieure soit conduite vers ladite bande de support supplémentaire (13c).

7. Module électronique de puissance selon la revendication 6, caractérisé en ce que lesdites plages de contact desdits premier et deuxième circuits intégrés sont reliées à l'extérieur dudit module par lesdites première et deuxième pièces de liaison inférieures et par ladite pièce de liaison inférieure supplémentaire.

8. Module électronique de puissance selon la revendication 7, caractérisé en ce qu'il comporte un troisième circuit intégré de puissance relié en parallèle soit avec ledit premier circuit intégré de puissance soit avec ledit deuxième circuit intégré de puissance.

9. Module électronique de puissance selon la revendication 8, caractérisé en ce qu'une première desdites plages de contact dudit troisième circuit intégré est juxtaposée avec un prolongement soit de ladite première pièce de liaison inférieure soit de ladite deuxième pièce de liaison inférieure.

10. Module électronique de puissance selon la revendication 9, caractérisé en ce que ledit prolongement de ladite première pièce de liaison inférieure ou de ladite deuxième pièce de liaison inférieure est pris en sandwich entre d'une part ledit troisième circuit intégré et d'autre part respectivement un prolongement de la première ou de la deuxième bande de fixation.

## Patentansprüche

1. Elektronischer Leistungsmodul, welcher mindestens einen ersten und einen zweiten integrierten Schaltkreis umfaßt, die auf einem Trägerwafer (1a, 1b) nebeneinander liegend angeordnet sind, wobei jeder der integrierten Schaltkreise zwei parallele und einander gegenüberliegende Stirnflächen umfaßt, wobei jede der Stirnflächen Kontaktbereiche für die integrierten Schaltkreise umfaßt, wobei der Modul femer Mittel zur elektrischen Verbindung und zur thermischen Leitung umfaßt, um einerseits die Kontaktbereiche mit dem Außenbereich des Moduls zu verbinden und andererseits die durch die integrierten Schaltkreise erzeugte Wärme abzuführen, dadurch gekennzeichnet, daß:
- die integrierten Schaltkreise integrierte Leistungsschaltkreise sind,
- die Mittel zum elektrischen Verbinden und zum thermischen Leiten vor allem von dem Waferträger hervorstehende Befestigungsstreifen (13a, 13b, 13c), die aus einem wärmeleitenden Material hergestellt sind und thermisch mit Mitteln (15) zur Wärmeabfuhr verbunden sind, und aus einem elektrisch und thermisch leitenden Material hergestellte obere Befestigungsstücke (7a, 9b) umfassen,
- der erste integrierte Schaltkreis (1b) zwischen einem ersten der Befestigungsstreifen (13b) und einem ersten der oberen Verbindungsstücke (9b) angeordnet ist, und der zweite integrierte Schaltkreis (1a) zwischen einem zweiten der Befestigungsstreifen (13a) und einem zweiten der oberen Befestigungsstücke (7a) angeordnet ist, wobei der erste und zweite Befestigungsstreifen jeweils eine obere, zu einer ersten der Stirnflächen, der unteren Stirnfläche, von einem der ersten und zweiten integrierten Schaltkreise (1a, 1b) parallele und gegenüberliegende Stimfläche aufweisen, und das erste und das zweite obere Verbindungsstück (7a, 9b) jeweils eine untere Stirnfläche aufweisen, die parallel und gegenüberliegend zu einer zweiten der Stirnflächen, der oberen Stirnfläche, von einem der ersten und zweiten integrierten Schaltkreise (1a, 1b) angeordnet ist,
- eine erste und eine zweite Feder (21a, 21b) vorgesehen sind, um das erste bzw. das zweite obere Verbindungsstück (7a, 9b) in Richtung auf den ersten und zweiten Befestigungsstreifen (13a, 13b) zurückzustellen, so daß der erste und der zweite integrierte Schaltkreis (1a, 1b) komprimiert werden und so ein elektrischer und thermischer Kontakt zwischen den Stirnflächen der integrierten Schaltkreise und den Mitteln zum elektrischen Verbinden und zum thermischen Leiten geschaffen wird, indem die erste und die zweite Feder (21a, 21b) im gespannten Zustand auf den Vorsprüngen des ersten und des zweiten Befestigungsstreifens (13a, 13b) befestigt werden.

2. Elektronischer Leistungsmodul nach Anspruch 1, dadurch gekennzeichnet, daß das zweite obere Verbindungsstück (7a) aus einem Teil eines Metallblechs (7) gebildet ist, von dem ein anderer Teil ein erstes unteres Verbindungsstück (7b) bildet, das zwischen dem ersten integrierten Schaltkreis (1b) und dem ersten Befestigungsstreifen (13b) angeordnet ist, so daß die durch den zweiten integrierten Schaltkreis (1a) auf Höhe seiner oberen Stimfläche erzeugte Wärme hin zum ersten Befestigungsstreifen (13b) geleitet und der zweite integrierte Schaltkreis (1a) elektrisch mit dem ersten integrierten Schaltkreis (1b) über die obere Stirnfläche des zweiten integrierten Schaltkreises (1a) verbunden ist.

3. Elektronischer Leistungsmodul nach Anspruch 1, dadurch gekennzeichnet, daß die Fedem (21a, 21b) aus einem leitenden Material hergestellt sind und daß Kappen (19a, 19b) aus einem isolierenden Material jeweils zwischen die oberen Verbindungsstücke (7a, 9b) einerseits und die Federn (21a, 21b) andererseits derart eingefügt sind, daß die oberen Verbindungsstücke von den Befestigungsstreifen (13a, 13b) isoliert sind.

4. Elektronischer Leistungsmodul nach einem der Ansprüche 1 bis 3, dadurch gekennzeichnet, daß ein zweites unteres Verbindungsstück (5a) zwischen dem zweiten integrierten Schaltkreis (1a) und dem zweiten Befestigungsstreifen (13a) angeordnet ist, und daß isolierende Schichten (17a, 17b) die unteren Verbindungsstücke (5a, 7b) von den Befestigungsstreifen (13a, 13b) trennen.

5. Elektronischer Leistungsmodul nach einem der Ansprüche 1 oder 2, dadurch gekennzeichnet, daß die isolierenden Schichten die Befestigungsstreifen von den Mitteln zur Abfuhr von Wärme trennen.

6. Elektronischer Leistungsmodul nach einem der Ansprüche 1, 2 oder 4, dadurch gekennzeichnet, daß das erste obere Verbindungsstück (9b) durch einen Teil eines Metallblechs (9) gebildet ist, von dem ein anderer Teil ein zusätzliches, an einem zusätzlichen Befestigungsstreifen (13c) befestigtes unteres Verbindungsstück (9c) bildet, so daß die durch den ersten integrierten Schaltkreis (1b) auf Höhe seiner oberen Stirnfläche erzeugte Wärme hin zum zusätzlichen Befestigungsstreifen (13c) geleitet wird.

7. Elektronischer Leistungsmodul nach Anspruch 6, dadurch gekennzeichnet, daß die Kontaktbereiche des ersten und zweiten integrierten Schaltkreises außerhalb des Moduls durch die ersten und zweiten unteren Verbindungsstücke und durch das zusätzliche untere Verbindungsstück gebildet werden.

8. Elektronischer Leistungsmodul nach Anspruch 7, dadurch gekennzeichnet, daß er einen dritten integrierten Leistungsschaltkreis umfaßt, der parallel entweder zum ersten integrierten Leistungsschaltkreis oder zum zweiten integrierten Leistungsschaltkreis geschaltet ist.

9. Elektronischer Leistungsmodul nach Anspruch 8, dadurch gekennzeichnet, daß ein erster der Kontaktbereiche des dritten integrierten Schaltkreises nebeneinander liegend zu einer Verlängerung entweder des ersten unteren Verbindungsstücks oder des zweiten unteren Verbindungsstücks angeordnet ist.

10. Elektronischer Leistungsmodul nach Anspruch 9, dadurch gekennzeichnet, daß die Verlängerung des ersten unteren Verbindungsstücks oder des zweiten unteren Verbindungsstücks in Sandwich-Anordnung zwischen dem dritten integrierten Schaltkreis einerseits und einer Verlängerung des ersten oder des zweiten Befestigungsstreifens andererseits angeordnet ist.

## Claims

1. Electronic power module comprising at least a first and a second integrated power circuits juxtaposed onto a support plate (1a, 1b), each of said integrated circuits comprising two faces which are parallel and opposite to each other, each of said faces comprising integrated circuit contact pads, said module also comprising electric connecting and thermal conductive means for, on the one hand, connecting said contact pads to the exterior of said module and, on the other hand, dissipating the heat produced by said integrated circuits, characterized in that :
- the integrated circuits are power integrated circuits,
- said electric connecting and thermal conductive means comprise in particular fixing strips (13a, 13b, 13c) protruding from said support plate which are made of a heat conducting material and thermally connected to heat dissipating means (15), and upper connecting parts (7a, 9b) made in an electric and heat conducting material,
- said first integrated circuit (1b) is arranged between a first of said fixing strips (13b) and a first of said upper connecting parts (9b), and said second integrated circuit (1a) being arranged between a second of said fixing strips (13a) and a second of said upper connecting parts (7a), said first and second fixing strips each having an upper face parallel and opposite to a first of said faces, called the lower face, of one of said first and second integrated circuits (1a, 1b), and said first and second upper connecting parts (7a, 9b) each comprising a lower face which is parallel and opposite to a second of said faces, called the upper face, of one of said first and second integrated circuits (1a, 1b)
- a first and a second springs (21a, 21b) are also provided for biaising respectively said first and second upper connecting parts (7a, 9b) in the direction of said first and second fixing strips (13a, 13b) so as to compress said first and second integrated circuits (la, 1b) and thus to make an electric and thermal contact between said faces of the integrated circuits (la, 1b) and said electric connecting and thermal conductive means, in that said first and second springs (21a, 21b) are attached on protruding portions of said first and second fixing strips (13a, 13b) so as to work under tension.

2. Electronic power module according to claim 1, characterized in that said second upper connecting part (7a) is formed by a part of a plate (7) another part of which forms a first lower connecting part (7b) arranged between said first integrated circuit (1b) and said first fixing strip (13b), so that the heat produced by said second integrated circuit (la) at its upper face is driven to said first fixing strip (13b) and that said second integrated circuit (1a) is electrically connected to said first integrated circuit (1b) via said upper face of said second integrated circuit (1a).

3. Electronic power module according to claim 1, characterized in that said springs (21a, 21b) are made in a conducting material and in that caps (19a, 19b) made in an insulating material are respectively inserted between, on the one hand, said upper connecting parts (7a, 9b) and, on the other hand, said springs (21a, 21b) so as to insulate said upper connecting parts from said fixing strips (13a, 13b).

4. Electronic power module according to one of claims 1 to 3, characterized in that a second lower connecting part (5a) is arranged between said second integrated circuit (la) and said second fixing strip (13a), and in that insulating layers (17a, 17b) separate said lower connecting parts (5a, 7b) from said fixing strips (13a, 13b).

5. Electronic power module according to one of claims 1 or 2, characterized in that insulating layers separate said fixing strips from said heat dissipating means.

6. Electronic power module according to one of claims 1, 2 or 4, characterized in that said first upper connecting part (9b) is formed by a part of a metal plate (9) another part of which forms an additional lower connecting part (9c) attached to an additional fixing strip (13c) so that the heat produced by said first integrated circuit (1b) at its upper face is driven to said additional fixing strip (13c).

7. Electronic power module according to claim 6, characterized in that said contact pads of said first and second integrated circuits are connected to the exterior of said module by said first and second lower connecting parts and by said additional lower connecting part.

8. Electronic power module according to claim 7, characterized in that it comprises a third integrated power circuit connected in parallel to either said first integrated power circuit or to said second integrated power circuit.

9. Electronic power module according to claim 8, characterized in that a first of said contact pads of said third integrated circuit is juxtaposed with an extension of either said first lower connecting part or said second lower connecting part.

10. Electronic power circuit according to claim 9, characterized in that said extension of said first lower connecting part or of said second lower connecting part is sandwiched between, on the one hand, said third integrated power circuit and, on the other hand, respectively an extension of the first or second fixing strip.
